# EUROPÄISCHE PATENTSCHRIFT

(11) **EP 1 151 536 B1**
(45) Veröffentlichungstag und Bekanntmachung des Hinweises auf die Patenterteilung: **06.11.2002**
(21) Anmeldenummer: 00906173.0
(22) Anmeldetag: 01.02.2000
(51) Int. Cl.: H03G 3/30

(54) **VERFAHREN UND ANORDNUNG ZUR LEISTUNGSREGELUNG EINES SENDEVERSTÄRKERS**
METHOD AND ARRANGEMENT FOR REGULATING THE POWER OF A TRANSMIT AMPLIFIER
PROCEDE ET DISPOSITIF DE REGULATION DE PUISSANCE D'UN AMPLIFICATEUR D'EMISSION

(30) Priorität: 11.02.1999 DE 19905731
(43) Veröffentlichungstag der Anmeldung: 07.11.2001
(73) Patentinhaber: SIEMENS AKTIENGESELLSCHAFT, 80333 München (DE)
(72) Erfinder: ECKERT, Rainer, D-81677 München (DE); FÜNFGELDER, Helmut, D-85386 Dietersheim (DE); MAMIER, Lothar, D-81241 München (DE); WANNENMACHER, Volker, D-81369 München (DE)
(86) Internationale Anmeldenummer: DE0000275
(87) Internationale Veröffentlichungsnummer: WO00048312

(56) Entgegenhaltungen:
- EP-A- 0 863 610
- WO-A-98/43371
- US-A- 5 394 159
- YAO-CHOU YANG ET AL: "Active patch antennas integrated with FETs using coupled transmission lines" IEEE ANTENNAS AND PROPAGATION SOCIETY INTERNATIONAL SYMPOSIUM 1997. DIGEST (CAT. NO.97CH36122), IEEE ANTENNAS AND PROPAGATION SOCIETY INTERNATIONAL SYMPOSIUM 1997. DIGEST, MONTREAL, QUE., CANADA, 13-18 JULY 1997, Seiten 6-9 vol.1, XP002137575 1997, New York, NY, USA, IEEE, USA ISBN: 0-7803-4178-3

## Beschreibung

Die Erfindung betrifft ein Verfahren und eine Anordnung zur Leistungsregelung eines Sendeverstärkers, insbesondere eines Sendeverstärkers eines Mobilfunkendgerätes.

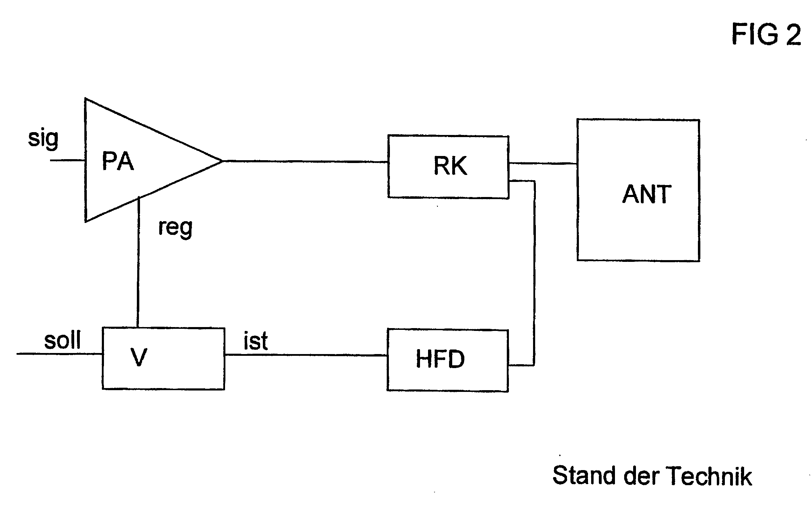

Figur 2 zeigt ein Prinzipschaltbild einer herkömmlichen Anordnung zur Leistungsregelung eines Sendeverstärkers (PA). Die dem Sendeverstärker (PA) zugeführten zu verstärkenden Signale (sig) werden gemäß einem dem Sendeverstärker (PA) zugeführten Regelparameter (reg), der ein Maß für die Verstärkung oder den Verstärkungsfaktor darstellt, verstärkt und einem Richtkoppler (RK) zugeführt. Der Richtkoppler (RK) koppelt einen kleinen Teil der von dem sendeverstärker (PA) der Antenne (ANT) zugeführten Leistung aus und führt sie einem Hochfrequenzdetektor (HFD) zu, der diese Leistung in eine Gleichspannung umwandelt. Dieser derart erzeugte Gleichspannungswert wird als Istwert (ist) einer Vergleichseinrichtung (V) zugeführt und dort mit einem durch eine Steuereinrichtung, wie beispielsweise einem Mikrocontroler eines Mobilfunkendgerätes, vorgegebenen Sollwert (soll) verglichen. Als Ergebnis des Vergleichs wird ein Regelparameter (reg) ausgegeben, der die Verstärkung des Sendeverstärkers (PA) so einstellt, daß der Istwert (ist) dem Sollwert (soll) entspricht. Dazu wird der Verstärkungsfaktor entsprechend der Differenz zwischen Soll- und Istwert erhöht oder erniedrigt. Der größere Teil der Leistung wird von dem Richtkoppler (RK) der Antenne(ANT) zugeführt, von der diese Leistung in Form von hochfrequenten Signalen abgestrahlt wird.

EP-0388894 offenbart die empfangsseitige Aufnahme eines Teils der sendeseitig von einer Antenne eines Mobilfunkendgerätes abgestrahlten Leistung. Dies bringt den Nachteil mit sich, daβ die Leistungsregelung unter Einbeziehung einer Basisstation und somit der Netzinfrastruktur erfolgt und somit erstens zu einer langsamen und trägen Regelung, zweitens zu einem zusätzlichen Signalisierungsaufwand zwischen Mobilstation und der Netzinfrastruktur führt und folglich drittens nur in Mobilfunkendgeräten einsetzbar ist, die in einem Mobilfunksystem betrieben werden, welches diese Art der Leistungsregelung unterstützt.

Es werden weltweit größte Anstrengungen unternommen, möglichst kleine und leichte Mobilfunkendgeräte zu entwickeln. Der Einsatz eines Richtkopplers steht diesem Wunsch entgegen, da er relativ groß, schwer und aufwendig zu realisieren ist.

Daher liegt der Erfindung die Aufgabe zugrunde, ein Verfahren und eine Anordnung zur Leistungsregelung eines Sendeverstärkers anzugeben, die es ermöglichen, die Leistungsregelung einfach und dennoch zuverlässig, insbesondere ohne den Einsatz eines Richtkopplers zu ermöglichen.

Diese Aufgabe wird durch die unabhängigen Patentansprüche gelöst. Vorteilhafte Weiterbildungen ergeben sich aus den Unteransprüchen.

Erfindungsgemäß wird ein Teil der von einer Antenne abgestrahlten Leistung aufgenommen und zur Leistungsregelung des Sendeverstärkers herangezogen.

Die Erfindung beruht also auf dem Gedanken, nicht einen Teil der vom Sendeverstärker ausgegebenen Leistung durch einen Richtkoppler auszukoppeln und diesen Teil der Leistung nach einer Weiterverarbeitung zur Leistungsregelung des Sendeverstärkers zu verwenden, sondern im wesentlichen die gesamte vom Sendeverstärker ausgegebene Leistung der Antenne eines Mobilfunkendgerätes zuzuführen, diese Leistung sendeseitig mittels der Antenne abzustrahlen, und einen Teil der abgestrahlten Leistung sendeseitig aufzunehmen, und diesen Teil der abgestrahlten Leistung nach einer eventuellen Weiterverarbeitung dem Sendeverstärker zur Leistungsregelung zuzuführen.

Dies hat den Vorteil, daß auf den aufwendigen Einsatz eines Richtkopplers verzichtet werden kann und die Leistungsregelung genauer durchgeführt werden kann, da die tatsächlich abgestrahlte Leistung bzw. ein Anteil davon zur Leistungsregelung herangezogen wird und nicht ein, wie im Stand der Technik üblich, Teil der Leistung, welche der Antenne erst noch zur Abstrahlung zugeführt wird.

Eine Weiterbildung der Erfindung sieht vor, daß eine Antenne und die Mittel zur Aufnahme der abgestrahlten Leistung auf einem Träger angeordnet sind, wodurch die Anordnung zur Leistungsregelung noch einfacher realisiert werden kann, insbesondere wenn die Mittel zur Aufnahme der abgestrahlten Leistung und die Antenne als planare oder Patchantenne realisiert werden. Unter "Mittel zur Aufnahme eines Teils der von einer Antenne abgestrahlten Leistung" versteht man im Rahmen der vorliegenden Anmeldung auch eine Antenne oder Teile einer Antenne, wie beispielsweise einen Resonator.

Im folgenden wird die Erfindung anhand bevorzugter Ausführungsbeispiele näher beschrieben, zu deren Erläuterung die nachstehend aufgelisteten Figuren dienen:
Figur 1 Prinzipschaltbild einer Anordnung zur Leistungsregelung eines Sendeverstärkers;
Figur 2 Prinzipschaltbild einer herkömmlichen Anordnung zur Leistungsregelung eines Sendeverstärkers;
Figur 3 Schematische Querschnittsdarstellung einer planaren Antenne bzw. eines planaren Koppelelementes;
Figur 4 Schematische Darstellung planarer Antennen mit Koppelelement auf einem Substrat;
Figur 5 Prinzipschaltbild einer Ausführungsvariante einer Anordnung zur Leistungsregelung eines Sendeverstärkers.

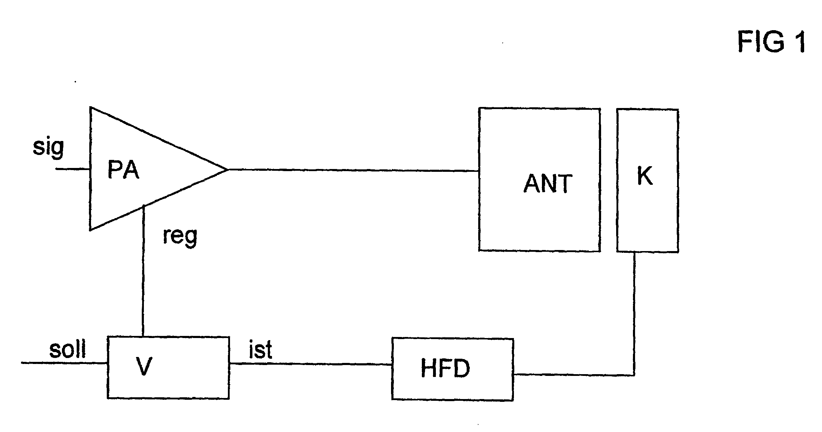

Figur 1 zeigt eine Antenne (ANT), die hochfrequente Signale mit einer durch die Verstärkung eines Sendeverstärkers (PA) bestimmten Leistung abstrahlt. Ein Koppelelement (K), das nach dem gleichen Prinzip wie eine Antenne realisiert sein kann, ist derart dimensioniert und angeordnet, daß es einen kleinen Teil der von der Antenne (ANT) abgestrahlten Leistung aufnimmt und damit einen Teil der von der Antenne (ANT) abgestrahlten Leistung auskoppelt. Dieser durch das Koppelelement (K) aufgenommene Teil der durch die Eintenne (ANT) abgestrahlten Leistung wird durch einen Hochfrequenzdetektor (HFD) in einen Gleichspannungswert umgesetzt, der damit ein Maß für die durch die Antenne (ANT) abgestrahlte Leistung darstellt. Dieser Gleichspannungswert wird als Istwert (ist) einer Vergleichseinrichtung (v), wie beispielsweise eine Komperatorschaltung zugeführt. In der Vergleichseinrichtung (v) wird dieser Istwert (ist) mit einem durch eine Steuereinrichtung wie beispielsweise dem Mikrocontroler eines Mobilfunkendgerätes zur Leistungsregelung vorgegebenen Sollwert (soll) verglichen. In Abhängigkeit von dem Vergleichsergebnis gibt die Versleichseinrichtung (v) einen Regelparameter (reg) aus, der den Verstärkungsfaktor des Sendeverstärkers (PA) so einstellt, daß die zu verstärkenden Signale (sig) mit einer Leistung von der Antenne (ANT) abgestrahlt werden, daß der Istwert (ist) dem Sollwert (soll) entspricht. Dazu wird der Verstärkungsfaktor entsprechend der Differenz zwischen Soll- und Istwert erhöht oder erniedrigt.

Um die Ausführungsbeispiele klar darzustellen, wurde in den Zeichnungen auf die Darstellung von Antennenschaltern, Diplexer oder Duplexer verzichtet.

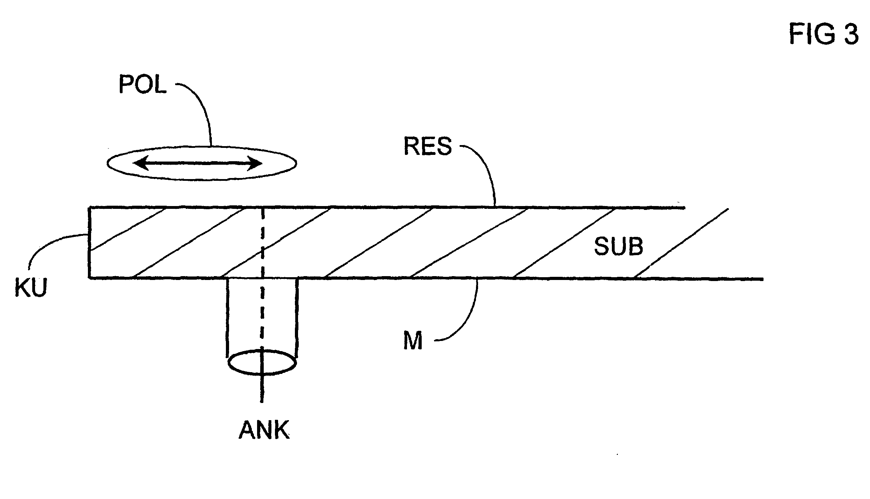

Zur Realisierung der Antenne (ANT) und/oder des Koppelelementes (K) bietet sich das Prinzip einer planaren Antenne oder Patchantenne an. Figur 3 zeigt eine Schnittdarstellung einer derartigen planaren Antenne oder Patchantenne bestehend aus einer Ankopplung (ANK), einer Massefläche (M), einem isolierenden, beispielsweise keramischen Substrat (SUB), einem Resonator (RES) und einem Kurzschluß (KU) zwischen Resonator (RES) und Massefläche (M). Durch den Doppelpfeil wird die Polarisationsrichtung (POL) einer derartigen Patchantenne angezeigt. Die Ankopplung der Signale kann auch anders als hier dargestellt beispielsweise kapazitiv erfolgen. Die Hochfrequenzzuführung bzw. Ankopplung kann mittels eines koaxialen Innenleiters realisiert werden.

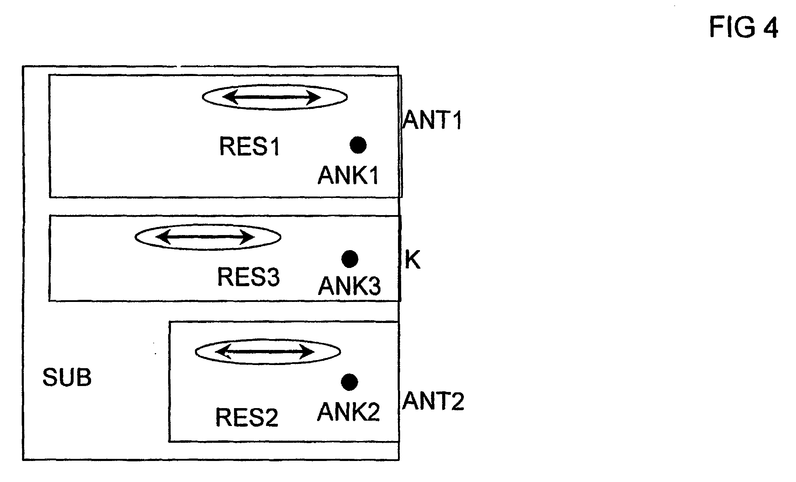

Figur 4 zeigt eine Antennenanordnung die entsprechend einem Sende- und Empfangsbetrieb aus zwei Antennen (ANT 1, ANT 2) besteht, die auf einem Träger, wie beispielsweise einer Platine oder einem Substrat (SUB), angeordnet sind mit entsprechenden Ankopplungen (ANK2), Resonatoren (RES1, RES2) und nicht dargestellten Kurzschlüssen zwischen Massefläche und Resonatoren. Die verstärkten hochfrequenten Signale werden der Sendeantenne (ANT1) über die Ankopplung (ANK1) vom Sendeverstärker (PA) zugeführt. Die über die entsprechend aufgebaute Empfangsantenne (ANT2) empfangenen Signale werden über die Ankopplung (ANK2) einem Empfangsverstärker zugeführt. Entweder auf einem anderen Substrat oder, wie in dieser Zeichnung beispielhaft dargestellt, auf dem gleichen Substrat kann das Koppelelement (K) ebenfalls nach dem Prinzip einer planaren Antenne bzw. Patachantenne realisiert sein. Dabei verfügt das Koppelelement (K) ebenfalls über einen Resonator (RES3) und eine Ankopplung (ANK3). Dabei ist der Koppelresonator (RES3)) über den Speisepunkt bzw. die Ankopplung (ANK3) mit dem Hochfrequenzdetektor (HFD) verbunden.

Bei Ausführungsvarianten der Erfindung kann es sich bei den unterschiedlichen Antennen auch um die Antennen einer Dualband-Antennenanordnung oder Multiband-Antennenanordnung handeln, die den Betrieb beispielsweise eines Mobilfunkendgerätes in unterschiedlichen Frequenzbereichen ermöglicht. Eine andere Ausführungsvariante sieht vor, daß jeweils für den Sende- und den Empfangsbereich zweier unterschiedlicher Frequenzbereiche unterschiedliche Antennen bzw. Resonatoren vorgesehen sind, was im Falle einer Dualband-Antennenanordnung durch das Anbringen von vier Resonatoren auf einem Substrat realisiert werden kann. Auch der Resonator des Koppelelementes (K) kann als fünfter Resonator auf demselben Substrat realisiert sein.

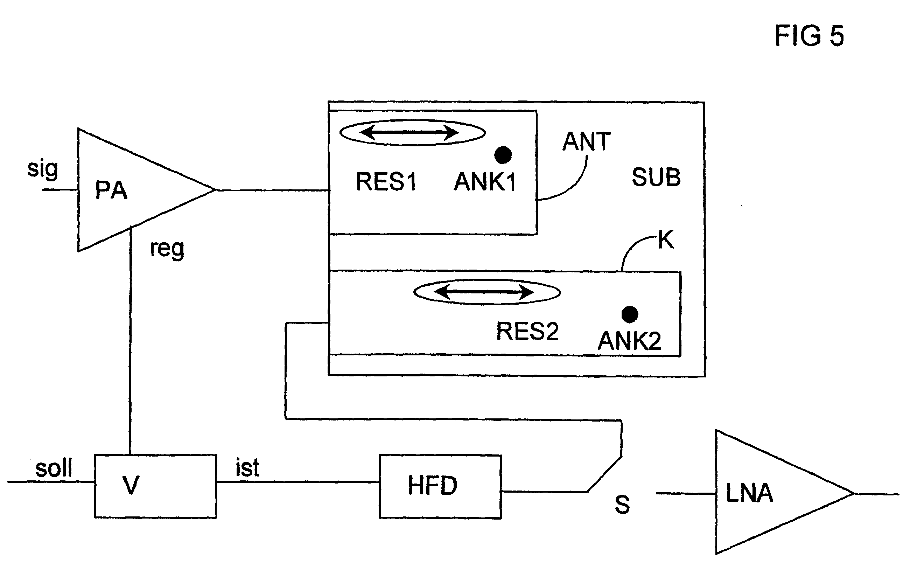

Figur 5 zeigt eine Antennenanordnung, bei welcher der Resonator (RES1) auf den Sendefrequenzbereich und der Resonator (RES2) auf den Empfangsfrequenzbereich abgestimmt ist. Während des Empfangs ist der Resoantor (RES2) aktiv und das Empfangssignal wird über eine Schalteinrichtung (S) dem Empfangsverstärker(LNA) zugeführt. Während des Sendens ist der Resonator (RES1) aktiv und der Resonator (RES2) übernimmt die Funktion eines Koppelelementes (K) dessen Ausgangssignal nun nach einem Umschalten der Schalteinrichtung (s) dem Hochfrequenzdetektor (HFD) zugeführt wird. Die Schalteinrichtung (S) kann dabei durch eine Steuereinrichtung, wie beispielsweise einen Mikrocontroler des Mobilfunkendgerätes gesteuert werden. Der Vergleich von Istwert (ist) und Sollwert (soll) und die davon abhängige Regelung des Sendeverstärkers (PA) wird entsprechend der Beschreibung zu Figur 1 durchgeführt. Eine Weiterbildung sieht vor, daß es sich bei der Antennenanordnung um eine Dualband-Antennenanordnung handelt, die vier Resonatoren umfaßt, wobei je ein Resonator zum Senden bzw. Empfangen in einem der beiden Frequenzbereichen vorgesehen ist. Im Sendebetrieb dienen die Empfangsresonatoren als Koppelelemente. Die Umschaltung der Empfangsresonatoren auf den Empfangsverstärker (LNA) bzw. Hochfrequenzdetektor (HFD) geschieht wie oben beschrieben mittels einer gesteuerten Schalteinrichtung.

## Patentansprüche

1. Verfahren zur Leistungsregelung eines Sendeverstärkers (PA) eines Mobilfunkendgerätes,
bei dem ein Teil der sendeseitig von einer Antenne (ANT) des Mobilfunkendgerätes abgestrahlten Leistung sendeseitig durch ein Koppelelement (K) des Mobilfunkendgerätes aufgenommen wird und sendeseitig zur Leistungsregelung des Sendeverstärkers (PA) des Mobilfunkendgerätes verwendet wird.

2. Anordnung zur Leistungsregelung eines Sendeverstärkers (PA) eines Mobilfunkendgerätes,
- mit Mitteln (K) zur Aufnahme eines Teils der von einer Antenne (ANT) des Mobilfunkendgerätes abgestrahlten Leistung, und
- mit Mitteln (V, PA) zur Regelung der Leistung des Sendeverstärkers (PA) des Mobilfunkendgerätes in Abhängigkeit von diesem aufgenommenen Teil der von der Antenne (ANT) des Mobilfunkendgerätes abgestrahlten Leistung.

3. Anordnung nach Anspruch 2,
bei der die Antenne des Mobilfunkendgerätes (ANT) als planare Antenne (ANT1) gebildet ist, wobei die planare Antenne einen ersten Resonator (RES1) umfaßt, welcher auf einem Substrat (SUB) aufgebracht ist,
bei der die Mittel (K) zur Aufnahme eines Teils der von der planaren Antenne (ANT1) des Mobilfunkendgerätes abgestrahlten Leistung einen zweiten Resonator (RES3) umfassen, und
bei der der erste Resonator (RES1) der planaren Antenne (ANT1) und der zweite Resonator (RES3) auf dem gleichen Substrat (SUB) aufgebracht sind.

4. Anordnung nach einem der Ansprüche 2 oder 3, bei der Mittel (K) zur Aufnahme eines Teils der von einer Antenne (ANT) abgestrahlten Leistung im Sendebetrieb des Mobilfunkendgerätes zumindest teilweise mittels der Empfangsantenne des Mobilfunkendgerätes realisiert sind.

## Claims

1. Method for controlling the power of a transmit amplifier (PA), of a mobile radio terminal,
in which a portion of the power transmitted at the transmission end from an antenna (ANT) of the mobile radio terminal is received at the transmission end by a coupling element (K) of the mobile radio terminal, and is used, at the transmission end, to control the power of the transmit amplifier (PA) of the mobile radio terminal.

2. Arrangement for controlling the power of a transmit amplifier (PA), of a mobile radio terminal,
- having means (K) for receiving a portion of the power transmitted from an antenna (ANT) of the mobile radio terminal, and
- having means (V, PA) for controlling the power of the transmit amplifier (PA) of the mobile radio terminal as a function of this received portion of the power transmitted from the antenna (ANT) of the mobile radio terminal.

3. Arrangement according to Claim 2,
in which the antenna of the mobile radio terminal (ANT) is in the form of a planar antenna (ANT1), with the planar antenna having a first resonator (RES1) which is mounted on a substrate (SUB),
in which the means (K) for receiving a portion of the power transmitted from the planar antenna (ANT1) of the mobile radio terminal have a second resonator (RES3), and
in which the first resonator (RES1) of the planar antenna (ANT1) and the second resonator (RES3) are mounted on the same substrate (SUB)

4. Arrangement according to one of Claims 2 or 3, in which
means (K) for receiving a portion of the power transmitted from an antenna (ANT) are provided, during transmission operation of the mobile radio terminal, at least partially by means of the receiving antenna of the mobile radio terminal.

## Revendications

1. Procédé de régulation de puissance d'un amplificateur d'émission (PA) d'un terminal de radiocommunication mobile,
dans lequel une partie de la puissance émise à l'émission par une antenne (ANT) du terminal de radiocommunication mobile est absorbée à l'émission par un élément de couplage (K) du terminal de radiocommunication mobile et utilisée à l'émission pour la régulation de puissance de l'amplificateur d'émission (PA) du terminal de radiocommunication mobile.

2. Arrangement pour réguler la puissance d'un amplificateur d'émission (PA) d'un terminal de radiocommunication mobile,
- avec des moyens (K) pour absorber une partie de la puissance émise par une antenne (ANT) du terminal de radiocommunication mobile et
- avec des moyens (V, PA) pour réguler la puissance de l'amplificateur d'émission (PA) du terminal de radiocommunication mobile en fonction de cette partie absorbée de la puissance émise par l'antenne (ANT) du terminal de radiocommunication mobile.

3. Arrangement selon la revendication 2,
dans lequel l'antenne (ANT) du terminal de radiocommunication mobile est réalisée comme antenne planaire (ANT1), ladite antenne planaire comprenant un premier résonateur (RES1) qui est appliqué sur un substrat (SUB),
dans lequel les moyens (K) pour absorber une partie de la puissance émise par l'antenne planaire (ANT1) du terminal de radiocommunication mobile comprennent un second résonateur (RES3) et
dans lequel le premier résonateur (RES1) de l'antenne planaire (ANT1) et le second résonateur (RES3) sont déposés sur le même substrat (SUB).

4. Arrangement selon l'une des revendications 2 ou 3,
dans lequel des moyens (K) pour absorber une partie de la puissance émise par une antenne (ANT) en mode émission du terminal de radiocommunication mobile sont réalisés au moins partiellement au moyen de l'antenne de réception du terminal de radiocommunication mobile.
